# EUROPEAN PATENT APPLICATION

(11) **EP 4 135 035 A1**
(43) Date of publication of application: **15.02.2023**
(21) Application number: 22792740.7
(22) Date of filing: 22.06.2022
(51) Int. Cl.: H01L 27/092

(54) **SEMICONDUCTOR STRUCTURE AND MANUFACTURING METHOD THEREFOR**

(30) Priority: 01.07.2021 CN 202110750664
(71) Applicant: Changxin Memory Technologies, Inc., Hefei, Anhui 230601 (CN)
(72) Inventor: SHEN, Yutong, Hefei, Anhui 230601 (CN); MU, Kejun, Hefei, Anhui 230601 (CN); XUE, Hui, Hefei, Anhui 230601 (CN)
(74) Representative: V.O.
(86) International application number: PCT/CN2022/100389
(87) International publication number: WO 2023/273979

(57) **Abstract**

Embodiments relate to a semiconductor structure and a fabrication method thereof. The semiconductor structure includes: a semiconductor substrate; a dielectric layer positioned on the semiconductor substrate; and a gate structure, including a bandgap-tunable material layer. The bandgap-tunable material layer is positioned on the dielectric layer, a Fermi level of the bandgap-tunable material layer shifts to a conduction band when electrons inflow, and the Fermi level of the bandgap-tunable material layer shifts to a valence band when the electrons outflow. The semiconductor structure and the fabrication method thereof can effectively reduce fabrication difficulty of the gate structure.

## Description

### CROSSREFERENCE TO RELATED APPLICATION

The present application claims priority to Chinese Patent Application No. 202110750664.X titled "SEMICONDUCTOR STRUCTURE AND FABRICATION METHOD THEREOF" and filed to the China National Intellectual Property Administration on July 1, 2021, the entire contents of which are incorporated herein by reference.

### TECHNICAL FIELD

The present application relates to the field of semiconductor technology, and more particularly, to a semiconductor structure and a fabrication method thereof.

### BACKGROUND

In the field of semiconductor device fabrication, as device sizes continue to shrink, thickness of gate dielectric layer silicon dioxide continues to decrease. However, due to limitations of shrinkage of oxide layers, when a thickness of a gate oxide layer is reduced below 2 nm, a larger gate leakage current becomes non-negligible. Therefore, high-k dielectrics are introduced during the fabrication of device dielectric layers. The high-k dielectrics can further increase the physical thicknesses of the gate dielectric layers on the basis of maintaining the same equivalent oxide thickness (EOT), thereby effectively reducing the leakage current and thus having better device switching characteristics.

With the introduction of the high-k dielectrics, the high-k dielectrics and traditional gate material polysilicon have problems such as Fermi pinning and boron penetration, and polysilicon gates also suffer from unavoidable depletion effect, which increases the thicknesses of the gate dielectric layers and reduces gate capacitance values, and thus leads to decline of drive capability of components. In view of these problems, metal gates are utilized to replace the traditional polysilicon gates, which has become inevitable for the further development of the devices.

To reduce metal-semiconductor barrier between a metal gate and a semiconductor substrate and form a good ohmic contact, for an NMOS transistor, a work function of the metal gate needs to be about 4.1eV; and for a PMOS transistor, a work function of the metal gate needs to be about 5.1 eV. In this case, it is difficult to find a metal that can satisfy the work function of the metal gate for both the NMOS transistor and the PMOS transistor, thus increasing fabrication difficulty of a gate structure. Meanwhile, due to presence of effects such as Fermi pinning, it is difficult for the metal gate to adjust a threshold voltage of the devices by adjusting a work function difference of a metal-semiconductor contact.

### SUMMARY

According to various embodiments of the present application, a semiconductor structure and a fabrication method thereof are provided.

According to various embodiments of the present application, there is provided a semiconductor structure, which includes: a semiconductor substrate; a dielectric layer positioned on the semiconductor substrate; and a gate structure comprising a bandgap-tunable material layer, wherein the bandgap-tunable material layer is positioned on the dielectric layer, a Fermi level of the bandgap-tunable material layer shifts to a conduction band when electrons inflow, and the Fermi level of the bandgap-tunable material layer shifts to a valence band when the electrons outflow.

According to some embodiments, the semiconductor structure may include an NMOS transistor and a PMOS transistor, and both the NMOS transistor and the PMOS transistor may include the gate structure.

According to some embodiments, the bandgap-tunable material layer may include a graphene film layer.

According to some embodiments, the dielectric layer may include an interface film layer and a high-k dielectric film layer, the interface film layer being positioned on a surface of the semiconductor substrate, the high-k dielectric film layer being positioned on a surface of the interface film layer, and the bandgap-tunable material layer being positioned on a surface of the high-k dielectric film layer.

According to some embodiments, the gate structure may further include a gate electrode positioned on the bandgap-tunable material layer.

According to some embodiments, a material of the gate electrode may include any one or more of metals, metal nitrides, metal silicides, and metal alloys.

According to some embodiments, the semiconductor structure may further include a sidewall protection layer, the sidewall protection layer being positioned on a sidewall of the gate structure and a sidewall of the dielectric layer, and the sidewall protection layer being configured to seal up the bandgap-tunable material layer jointly with the gate electrode.

According to some embodiments, the semiconductor substrate positioned on two opposite sides of the gate structure may form a source region and a drain region. The semiconductor structure may further include a source electrode and a drain electrode, the source electrode being positioned on the source region, and the drain electrode being positioned on the drain region.

According to various embodiments of the present application, there is also provided a method for fabricating a semiconductor structure, including: providing a semiconductor substrate; forming a dielectric layer on the semiconductor substrate; and forming a gate structure on the dielectric layer, where the gate structure includes a bandgap-tunable material layer positioned on the dielectric layer, a Fermi level of the bandgap-tunable material layer shifts to a conduction band when electrons inflow, and the Fermi level of the bandgap-tunable material layer shifts to a valence band when the electrons outflow.

According to some embodiments, the semiconductor substrate may include a shallow trench isolation structure and a plurality of device regions isolated by the shallow trench isolation structure, each of the plurality of device regions comprising an N-type well region and a P-type well region, the P-type well region being configured to form an NMOS transistor, the N-type well region being configured to form a PMOS transistor, and the dielectric layer and the gate structure being formed on both the N-type well region and the P-type well region.

According to some embodiments, the forming a gate structure on the dielectric layer may include: forming a graphene film layer on the dielectric layer.

According to some embodiments, the forming a dielectric layer on the semiconductor substrate may include: forming an interface material layer on a surface of the semiconductor substrate; forming a high-k material layer on a surface of the interface material layer; and patterning the interface material layer and the high-k material layer to form an interface film layer and a high-k dielectric film layer positioned on a surface of the interface film layer. Wherein, the forming a gate structure on the dielectric layer may include: forming the bandgap-tunable material layer on a surface of the high-k dielectric film layer.

According to some embodiments, the forming a gate structure on the dielectric layer may include: forming a gate electrode on the bandgap-tunable material layer.

According to some embodiments, after the forming a gate structure on the dielectric layer, the method may further include: forming a sidewall protection layer on a sidewall of the gate structure and on a sidewall of the dielectric layer, the sidewall protection layer being configured to seal up the bandgap-tunable material layer jointly with the gate electrode.

According to some embodiments, after the forming a sidewall protection layer on a sidewall of the gate structure and on a sidewall of the dielectric layer, the method may further include: performing ion implantation on the semiconductor substrate positioned on two opposite sides of the gate structure to form a source region and a drain region on the two opposite sides of the gate structure; and forming a source electrode on the source region, and forming a drain electrode on the drain region.

The embodiments of the present application may/at least have following advantages.

The gate structure includes a bandgap-tunable material layer. The bandgap-tunable material layer is positioned on the dielectric layer. Moreover, a Fermi level of the bandgap-tunable material layer shifts to a conduction band when electrons inflow, and the Fermi level of the bandgap-tunable material layer shifts to a valence band when the electrons outflow.

Therefore, for the NMOS transistor, when its gate structure receives a high-level gate voltage signal, the electrons flow from the semiconductor substrate into the bandgap-tunable material layer, such that the Fermi level of the bandgap-tunable material layer shifts to the conduction band. Therefore, when an appropriate gate voltage signal is applied, the Fermi level of the bandgap-tunable material layer may exhibit characteristics of an N-type semiconductor.

For the PMOS transistor, when a low-level voltage is applied to its gate structure, the electrons flow from the bandgap-tunable material layer to the semiconductor substrate, such that the Fermi level of the bandgap-tunable material layer shifts to the valence band. Therefore, when an appropriate gate voltage signal is applied, the Fermi level of the bandgap-tunable material layer may exhibit characteristics of a P-type semiconductor.

Therefore, the gate structure of the embodiments of the present application can adjust the gate voltage while meeting work function requirements of the NMOS transistor and the PMOS transistor for the gate structure, thereby effectively reducing manufacturing difficulty of the gate structure in the fabrication process a semiconductor device.

Meanwhile, further, the graphene film layer may be used as the bandgap-tunable material layer. In this case, because graphene has a special Dirac-cone band structure, it can effectively eliminate the Fermi pinning effect generated when a metal gate structure is in direct contact with the dielectric layer, thereby avoiding its adverse effects on the threshold voltage of the device.

Details of one or more embodiments of the present application are set forth in the following drawings and descriptions. Other features, objectives, and advantages of the present application will become apparent from the description, the drawings, and the claims.

### BRIEF DESCRIPTION OF THE DRAWINGS

To describe the technical solutions of the embodiments of the present application or those of the prior art more clearly, the accompanying drawings required for describing the embodiments or the prior art will be briefly introduced below. Apparently, the accompanying drawings in the following description are merely some embodiments of the present application. To those of ordinary skills in the art, other accompanying drawings may also be derived from these accompanying drawings without creative efforts.
FIG. 1 illustrates a schematic cross-sectional view of a semiconductor structure provided in an embodiment;
FIG. 2(a) is a schematic cross-sectional view of a semiconductor structure provided in another embodiment;
FIG. 2(b) is a schematic plan view of the semiconductor structure provided in another embodiment;
FIG. 3 is a schematic diagram of a Dirac-cone band structure of graphene;
FIG. 4 is a schematic diagram of band shift process when a P-type graphene film layer is used as a bandgap-tunable material layer;
FIG. 5 is a schematic diagram illustrating fabrication procedures of a semiconductor structure provided in an embodiment;
FIG. 6 is a schematic diagram illustrating fabrication procedures of a semiconductor structure provided in another embodiment;
In FIGS. 7 to 12, FIG. (a) of each figure is a schematic cross-sectional view of each step of the fabrication procedures; and

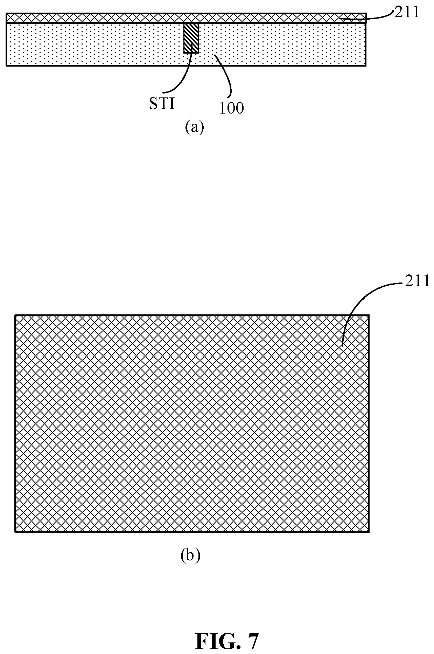

In FIGS. 7 to 12, FIG. (b) of each figure is a schematic plan view of each step of the fabrication procedures.

Reference numerals in the accompanying drawings: 100-semiconductor substrate, 110-source region, 120-drain region, 130-channel region, 200-dielectric layer, 211-interface material layer, 210-interface film layer, 220-high-k dielectric film layer, 221-high-k material layer, 300-gate structure, 310-bandgap-tunable material layer, 320-gate electrode, 400-sidewall protection layer, 510-source electrode, and 520-drain electrode.

To better describe and illustrate the embodiments and/or examples of those inventions disclosed herein, one or more drawings may be referred to. The additional details or examples for describing the drawings should not be considered as limiting the scope of any of the disclosed inventions, the currently described embodiments and/or examples, and the best mode of these inventions currently understood.

### DETAILED DESCRIPTION

For ease of understanding the present application, the present application will be described more fully hereinafter with reference to the accompanying drawings. Embodiments of the present application are presented in the accompanying drawings. However, the present application may be embodied in many different forms and should not be limited to the embodiments set forth herein. Rather, these embodiments are provided such that the present application will be more thorough and complete.

Unless otherwise defined, all technical and scientific terms employed herein have the same meaning as commonly understood by one of ordinary skill in the art to which the present application belongs. The terms employed in the specification of the present application are merely for the purpose of describing some embodiments and are not intended for limiting the present application.

It should be understood that when an element or layer is referred to as being "on", "adjacent to", "connected to" or "coupled to" other elements or layers, it may be directly on, adjacent to, connected or coupled to the other elements or layers, or intervening elements or layers may be present. In contrast, when an element is referred to as being "directly on", "directly adjacent to", "directly connected to" or "directly coupled to" other elements or layers, there are no intervening elements or layers present. It should be understood that although the terms first, second, third, etc. may be employed to describe various elements, components, regions, layers, doping types and/or sections, these elements, components, regions, layers, doping types and/or sections should not be limited by these terms. These terms are only employed to distinguish one element, component, region, layer, doping type, or section from another element, component, region, layer, doping type, or section. Thus, a first element, component, region, layer, doping type or section discussed below may be termed a second element, component, region, layer or section without departing from the teachings of the present application. For example, a first conductivity type may become a second conductivity type, and similarly, the second conductivity type may become the first conductivity type. The first conductivity type and the second conductivity type are different conductivity types. For example, the first conductivity type may be P-type and the second conductivity type may be N-type, or the first conductivity type may be N-type and the second conductivity type may be P-type.

Spatially relative terms such as "below", "under", "lower", "beneath", "above", "upper" and the like may be used herein to describe relationships between one element or feature as shown in the figures and another element(s) or feature(s). It should be understood that the spatially relative terms may be intended to encompass different orientations of a device in use or operation in addition to the orientation depicted in the figures. For example, if the device in the figures is turned over, elements or features described as "under", "beneath" or "below" other elements would then be oriented "above" the other elements or features. Thus, the example term "under", "below" or "beneath" may encompass both an orientation of above and below. In addition, the device may also be otherwise oriented (for example, rotated 90 degrees or at other orientations) and the spatially relative descriptors used herein should be interpreted accordingly.

As used herein, the singular forms of "a", "one" and "said/the" are also intended to include plural forms, unless the context clearly indicates otherwise. It should also be understood that the terms "comprising" and/or "including", when used in this specification, may determine the presence of the described features, integers, steps, operations, elements and/or components, but do not preclude the presence or addition of one or more other features, integers, steps, operations, elements, components, and/or groups thereof. Meanwhile, as used herein, the term "and/or" includes any and all combinations of related listed items.

Embodiments of the present application are described herein with reference to cross-sectional illustrations serving as schematic illustrations of idealized embodiments (and intermediate structures) of the present application. As such, variations from the shapes of the illustrations as a result, for example, of manufacturing techniques and/or tolerances, may be expected. Thus, the embodiments of the present application should not be construed as being limited to particular shapes of regions illustrated herein but may include deviations in shapes that result, for example, from the manufacturing techniques. Thus, regions illustrated in the figures are schematic in nature and their shapes neither illustrate an actual shape of a region of the device nor limit the scope of the present application.

As mentioned in the background art, the metal gates have become inevitable for the further development of semiconductor devices. However, it is difficult for the same metal gate to meet the requirements of both NMOS transistors and PMOS transistors, thereby increasing the manufacturing difficulty of a gate structure.

In the related technologies, to reduce metal-semiconductor barriers between the metal gates and semiconductor substrates, work functions of the metal gates of the PMOS transistors and work functions of the metal gates of the NMOS transistors are generally adjusted by means of a double gate metal process and a gate stack layer. However, this increases difficulties and requirements of the manufacturing process of the gate structure. Moreover, problems such as Fermi pinning are easily formed between the metal gates and high-k dielectrics, resulting in a greater threshold voltage, which is disadvantageous to improving device performance.

Based on the above reasons, the present application provides a semiconductor structure and a fabrication method thereof.

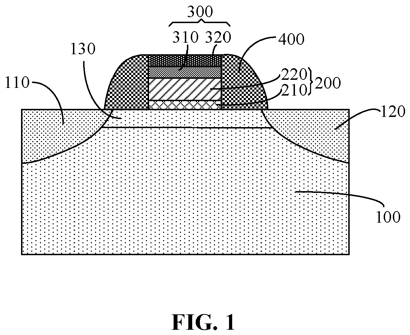

In one embodiment, referring to FIG. 1, a semiconductor structure is provided, which includes a semiconductor substrate 100, a dielectric layer 200, and a gate structure 300.

The semiconductor substrate 100 may include, but is not limited to, a silicon substrate. A source region 110, a drain region 120 and a channel region 130 may be formed in the semiconductor substrate 100. The source region 110 and the drain region 120 may be formed by heavily doping the semiconductor substrate 100 with inversion-type ions. The channel region 130 is a conductive channel formed between the source region 110 and the drain region 120 when a voltage is applied to a gate of a transistor to turn on the transistor.

The dielectric layer 200 is positioned on the semiconductor substrate 100 and is positioned above the channel region 130. The dielectric layer 200 may include a high-k dielectric film layer 220 to reduce gate leakage current in small-sized devices. Of course, the dielectric layer 200 may also not include the high-k dielectric film layer. The present application is not limited thereto.

The gate structure 300 includes a bandgap-tunable material layer 310. The bandgap-tunable material layer 310 is positioned on the dielectric layer 200. Moreover, a Fermi level of the bandgap-tunable material layer 310 shifts to a conduction band when electrons inflow, and the Fermi level of the bandgap-tunable material layer 310 shifts to a valence band when the electrons outflow.

Therefore, for the NMOS transistor, when its gate structure 300 receives a high-level gate voltage signal, the electrons flow from the semiconductor substrate 100 into the bandgap-tunable material layer 310, such that the Fermi level of the bandgap-tunable material layer 310 shifts to the conduction band. Therefore, when an appropriate gate voltage signal is applied, the Fermi level of the bandgap-tunable material layer 310 may exhibit characteristics of an N-type semiconductor. In this case, a metal-semiconductor work function difference between the gate structure 300 and the channel region 130 forming an N-type conductive channel can be effectively reduced, such that a barrier between the gate structure 300 and the channel region 130 forming the N-type conductive channel is reduced, thereby forming a good ohmic contact and effectively improving device performance.

For the PMOS transistor, when a low-level voltage is applied to its gate structure 300, the electrons flow from the bandgap-tunable material layer 310 to the semiconductor substrate 100, such that the Fermi level of the bandgap-tunable material layer 310 shifts to the valence band. Therefore, when an appropriate gate voltage signal is applied, the Fermi level of the bandgap-tunable material layer 310 may exhibit characteristics of a P-type semiconductor. In this case, a metal-semiconductor work function difference between the gate structure 300 and the channel region 130 forming a P-type conductive channel can be effectively reduced, such that a barrier between the gate structure 300 and the channel region 130 forming the P-type conductive channel is reduced, thereby forming a good ohmic contact and effectively improving device performance.

Therefore, in this embodiment, the gate structure 300 can meet the requirements of the NMOS transistor and the PMOS transistor by applying different voltages, such that difficulty of manufacturing the gate structure in the fabrication process of the semiconductor device can be effectively reduced.

It is to be understood that the conductivity type of the bandgap-tunable material layer 310 may be N-type, P-type, or intrinsic non-doped type, which is not limited in the present application.

In one embodiment, the semiconductor structure includes an NMOS transistor and a PMOS transistor, and both the NMOS transistor and the PMOS transistor include the gate structure.

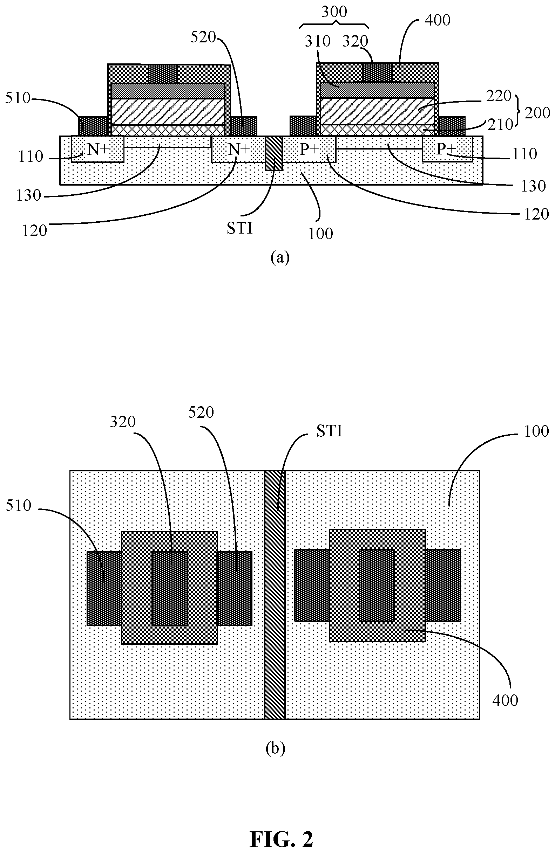

As an example, referring to FIG. 2(a) and FIG. 2(b), in this case, the NMOS transistor and the PMOS transistor may form a CMOS device. The CMOS device is a complementary MOS device comprising the PMOS transistor and the NMOS transistor. In the CMOS device, each CMOS subcircuit includes a pair of PMOS transistors and NMOS transistors.

Of course, the NMOS transistor and the PMOS transistor in this embodiment may not form the CMOS device. In other embodiments, the semiconductor structure may also only include the NMOS transistors or only include the PMOS transistors. In some embodiments, the semiconductor structure may also include other types of field effect transistors. The present application is not limited thereto.

In one embodiment, the bandgap-tunable material layer 310 includes a graphene film layer.

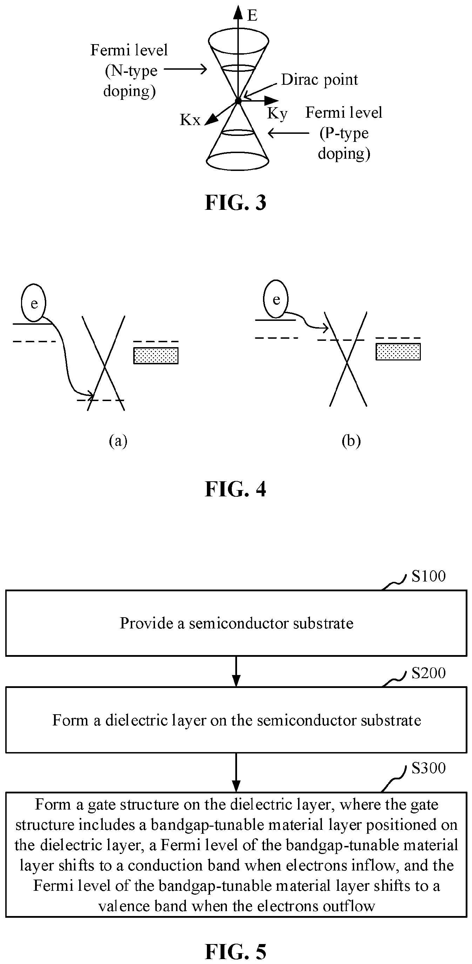

As an emerging two-dimensional material, graphene has advantages of higher melting point and higher mobility, etc. Moreover, as shown in FIG. 3, graphene has a special Dirac-cone band structure, such that bandgap of the graphene is tunable, and thus graphene may be used as the bandgap-tunable material layer 310.

Furthermore, because graphene has the special Dirac-cone band structure, it can effectively eliminate the Fermi pinning effect generated when a metal gate structure is in direct contact with the dielectric layer, thereby avoiding its adverse effects on the threshold voltage of the device.

As an example, the bandgap-tunable material layer 310 may be a P-type graphene film layer. In this case, referring to FIG. 4, for the NMOS transistor, after an appropriate gate voltage signal is applied to its gate structure, the electrons flow into the bandgap-tunable material layer 310, and the Fermi level of the corresponding bandgap-tunable material layer 310 shifts to the conduction band. Therefore, the conductivity type of the bandgap-tunable material layer 310 corresponding to the NMOS transistor may be changed from P-type to N-type, referring to FIG. 4(a), to meet energy level requirements of the NMOS transistor. As for the PMOS transistor, after an appropriate gate voltage signal is applied to its gate structure, the electrons flow out of the bandgap-tunable material layer 310, and the Fermi level of the bandgap-tunable material layer 310 shifts to the valence band. Therefore, the conductivity type of the bandgap-tunable material layer 310 corresponding to the PMOS transistor is still P-type, to meet the energy level requirements of the PMOS transistor.

Of course, the bandgap-tunable material layer 310 may also be an N-type graphene film layer or an intrinsic non-doped graphene film layer or the like.

When the bandgap-tunable material layer 310 is the N-type graphene film layer, for the PMOS transistor, after an appropriate gate voltage signal is applied to its gate structure, the electrons flow out of the bandgap-tunable material layer 310, and the Fermi level of the gap-tunable material layer 310 shifts to the valence band. Therefore, the conductivity type of the bandgap-tunable material layer 310 corresponding to the PMOS transistor may be changed from N-type to P-type, to meet the energy level requirements of the PMOS transistor. For the NMOS transistor, after an appropriate gate voltage signal is applied to its gate structure, the electrons flow into the bandgap-tunable material layer 310, and the Fermi level of the corresponding bandgap-tunable material layer 310 shifts to the conduction band. Therefore, the conductivity type of the bandgap-tunable material layer 310 corresponding to the NMOS transistor is still N-type, referring to FIG. 4(b), to meet the energy level requirements of the NMOS transistor.

When the bandgap-tunable material layer 310 is an intrinsic non-doped graphene film layer, the Fermi level is near a Dirac point. In this case, for the PMOS transistor, after an appropriate gate voltage signal is applied to its gate structure, the Fermi level of the corresponding bandgap-tunable material layer 310 shifts from the Dirac point to the valence band. Therefore, the conductivity type of the bandgap-tunable material layer 310 corresponding to the PMOS transistor may be changed to P-type, to meet the energy level requirements of the PMOS transistor. For the NMOS transistor, after an appropriate gate voltage signal is applied to its gate structure, the Fermi level of the corresponding bandgap-tunable material layer 310 shifts from the Dirac point to the conduction band. Therefore, the conductivity type of the bandgap-tunable material layer 310 corresponding to the NMOS transistor is changed to N-type, to meet the energy level requirements of the NMOS transistor.

In one embodiment, referring to FIG. 1 or FIG. 2(a), the dielectric layer 200 includes an interface film layer 210 and a high-k dielectric film layer 220. The interface film layer 210 is positioned on a surface of the semiconductor substrate 100, the high-k dielectric film layer 220 is positioned on a surface of the interface film layer 210, and the bandgap-tunable material layer 310 is positioned on a surface of the high-k dielectric film layer 220.

When the high-k dielectric film layer is directly applied to the semiconductor substrate 100, an oxygen vacancy or the like may be generated, which may lead to interface defects between the high-k dielectric film layer and the semiconductor substrate 100.

The formation of the interface film layer 210 can effectively reduce the interface defects. In addition, the interface film layer 210 can also improve thermal stability, reduce tunneling of the high-k dielectric film layer 220, and improve carrier mobility through the channel region of the transistor.

The bandgap-tunable material layer 310 is positioned on the surface of the high-k dielectric film layer 220, such that the barrier between the gate structure 300 and the semiconductor substrate 100 can be effectively reduced.

In one embodiment, referring to FIG. 1 or FIG. 2(a), the gate structure 300 further includes a gate electrode 320. The gate electrode 320 is positioned on the bandgap-tunable material layer 310. The arrangement of the gate electrode 320 may facilitate applying an external gate voltage signal to the bandgap-tunable material layer 310.

A width of the gate electrode 320 may be equal to that of the bandgap-tunable material layer 310, referring to FIG. 1; and the width of the gate electrode 320 also may be smaller than that of the bandgap-tunable material layer 310, referring to FIG. 2(a). The present application does not limit a relationship between the width of the gate electrode 320 and the width of the bandgap-tunable material layer 310.

As an example, a material of the gate electrode 320 may include metal, metal nitride, metal silicide, and metal alloy, etc.

Further, a material may be selected for the gate electrode 320 such that a work function of the gate electrode 320 ranges between 4.1 eV and 5.1 eV. For example, titanium nitride (TiN) is selected as the material of the gate electrode 320. In addition, adjustment of metal work functions of NMOS and PMOS can be satisfied.

In one embodiment, referring to FIG. 1 or FIG. 2(a), the semiconductor structure may further include a sidewall protection layer 400. A material of the sidewall protection layer 400 is an insulating material, and the sidewall protection layer 400 is positioned on a sidewall of the gate structure 300 and a sidewall of the dielectric layer 200 to protect the sidewalls.

In addition, the sidewall protection layer 400 is configured to seal up the bandgap-tunable material layer 310 jointly with the gate electrode 320, to effectively protect the bandgap-tunable material layer 310.

In one embodiment, referring to FIG. 2(a), the semiconductor substrate 100 positioned on two opposite sides of the gate structure 300 forms the source region 110 and the drain region 120.

The semiconductor structure further includes a source electrode 510 and a drain electrode 520. The source electrode 510 is positioned on the source region 110, and is configured to apply a source voltage signal to the source region 110. The drain electrode 520 is positioned on the drain region 120, and is configured to apply a drain voltage signal to the drain region 120.

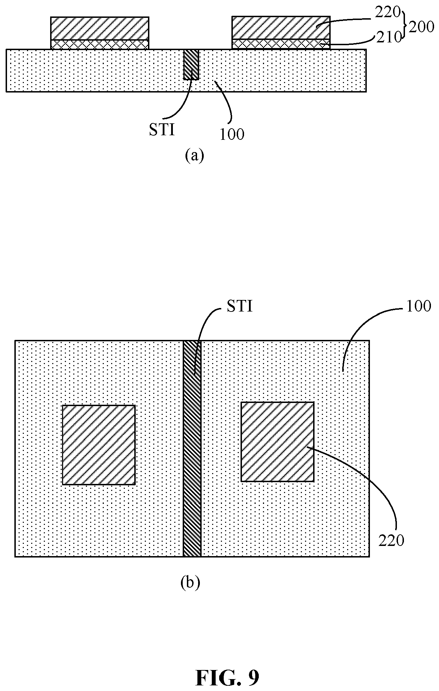

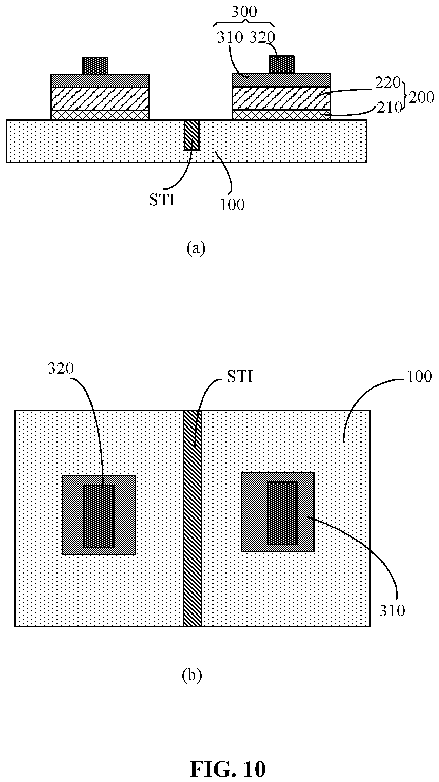

In one embodiment, referring to FIG. 5, there is provided a method for fabricating a semiconductor structure, including following steps:
Step S100, providing a semiconductor substrate 100, referring to FIG. 7(a);
Step S200, forming a dielectric layer 200 on the semiconductor substrate 100, referring to FIG. 9(a); and
Step S300, forming a gate structure 300 on the dielectric layer 200, where the gate structure 300 includes a bandgap-tunable material layer 310 positioned on the dielectric layer 200, a Fermi level of the bandgap-tunable material layer 310 shifts to a conduction band when electrons inflow, and the Fermi level of the bandgap-tunable material layer 310 shifts to a valence band when the electrons outflow, referring to FIG. 10(a).

The gate structure 300 in this embodiment includes the bandgap-tunable material layer 310, so it can meet the requirements of both the NMOS transistors and the PMOS transistors, such that the difficulty of manufacturing the gate structure in the fabrication process of the semiconductor device can be effectively reduced.

In addition, the bandgap-tunable material layer 310 of the gate structure 300 in this embodiment can effectively avoid the Fermi pinning by utilizing the feature of bandgap tunability.

It is to be understood that the conductivity type of the bandgap-tunable material layer 310 may be N-type, P-type, or non-doped type, which is not limited in the present application.

In one embodiment, the semiconductor substrate 100 includes a shallow trench isolation structure STI and a plurality of device regions isolated by the shallow trench isolation structure STI. Each of the plurality of device regions includes an N-type well region and a P-type well region. The P-type well region is configured to form an NMOS transistor, and the N-type well region is configured to form a PMOS transistor.

In this case, as an example, the method for fabricating the semiconductor substrate 100 may include:
Step S 110, providing a substrate having a first conductivity type;
Step S112, forming a shallow trench isolation structure STI in the substrate, where the shallow trench isolation structure STI isolates the substrate into a plurality of device regions; and
Step S113, performing ion implantation of a second conductivity type on part of the device regions to form an active area having the second conductivity type, where remaining part of the device regions constitute an active area having the first conductivity type.

The first conductivity type is N-type or P-type. When the first conductivity type is N-type, the second conductivity type is P-type. When the first conductivity type is P-type, the second conductivity type is N-type.

In this case, the shallow trench isolation structure STI formed in Step S112 can effectively prevent ions having the second conductivity type from entering the active area having the first conductivity type when the ion implantation of the second conductivity type is performed in Step S113.

Of course, the method for fabricating the semiconductor substrate 100 is not limited thereto. For example, in another embodiment, the method for fabricating the semiconductor substrate 100 may also include:
Step S121, providing a substrate having the first conductivity type;
Step S122, performing ion implantation of the second conductivity type on part of the substrate region to form a well region having the second conductivity type; and
Step S123, forming a shallow trench isolation structure STI between an implanted region and a non-implanted region of the ion implantation of the second conductivity type in the substrate, the trench isolation structure STI isolating the substrate into a plurality of device regions, where part of the device regions on which the ion implantation of the second conductivity type is performed constitute an active area having the second conductivity type, and remaining part of the device regions constitute an active area having the first conductivity type.

In this embodiment, the dielectric layer 200 and the gate structure 300 are formed on both the N-type well region and the P-type well region, such that the NMOS transistor and the PMOS transistor may be formed through the same dielectric layer and gate structure process, thereby effectively reducing difficulty and complexity of the process.

In one embodiment, Step S300 includes:
Step S311, forming a graphene film layer on the dielectric layer 200. In this case, the graphene film layer constitutes the bandgap-tunable material layer 310.

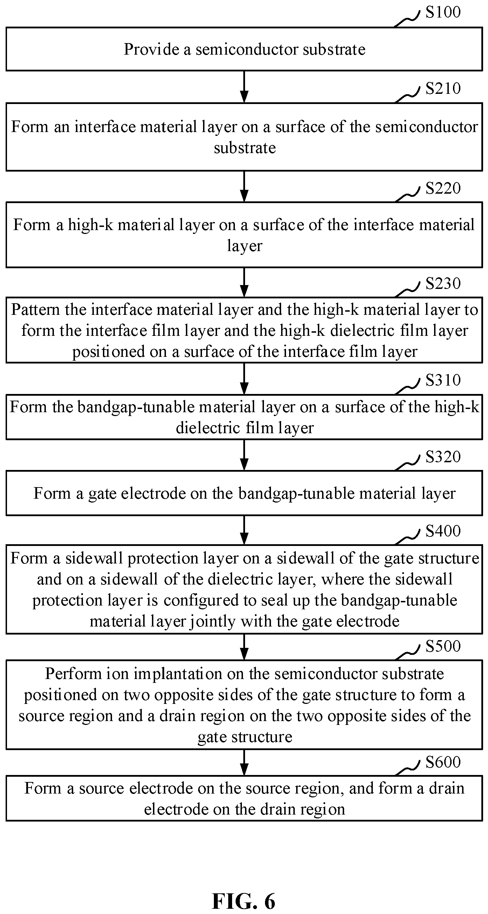

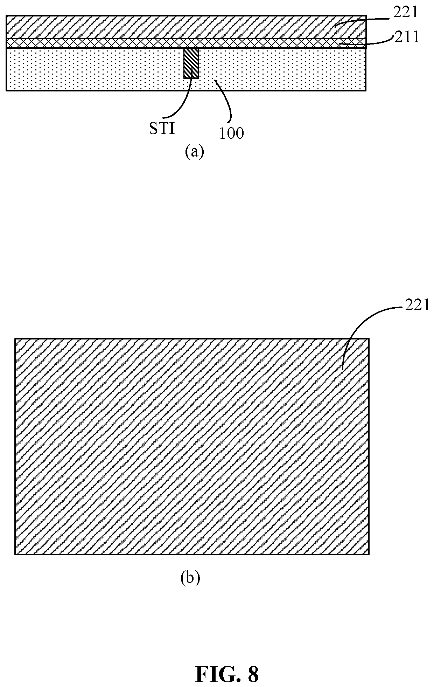

In one embodiment, referring to FIG. 6, Step S200 also includes:
Step S210, forming an interface material layer 211 on a surface of the semiconductor substrate 100, referring to FIG. 7(a) and FIG. 7(b);
Step S220, forming a high-k material layer 221 on a surface of the interface material layer 211, referring to FIG. 8(a) and FIG. 8(b);
Step S230, patterning the interface material layer 211 and the high-k material layer 221 to form the interface film layer 210 and the high-k dielectric film layer 220 positioned on a surface of the interface film layer 210, referring to FIG. 9(a) and FIG. 9(b).

In this case, Step S300 includes:
Step S310, forming the bandgap-tunable material layer 310 on a surface of the high-k dielectric film layer 220, referring to FIG. 10(a) and FIG. 10(b).

In one embodiment, referring to FIG. 6, Step S300 includes:
Step S320, forming a gate electrode 320 on the bandgap-tunable material layer, with continued reference to FIG. 10(a) and FIG. 10(b).

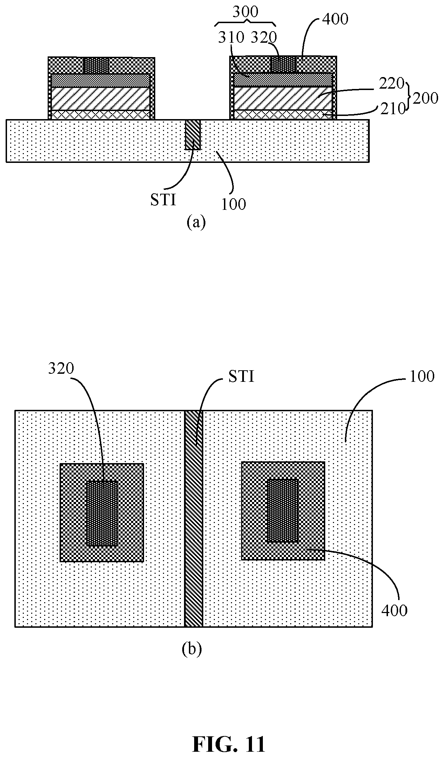

In one embodiment, referring to FIG. 6, after Step S300, the method also includes:
Step S400, forming a sidewall protection layer 400 on a sidewall of the gate structure 300 and on a sidewall of the dielectric layer 200, where the sidewall protection layer 400 is configured to seal up the bandgap-tunable material layer 310 jointly with the gate electrode 320, referring to FIG. 11 (a) and FIG. 11 (b).

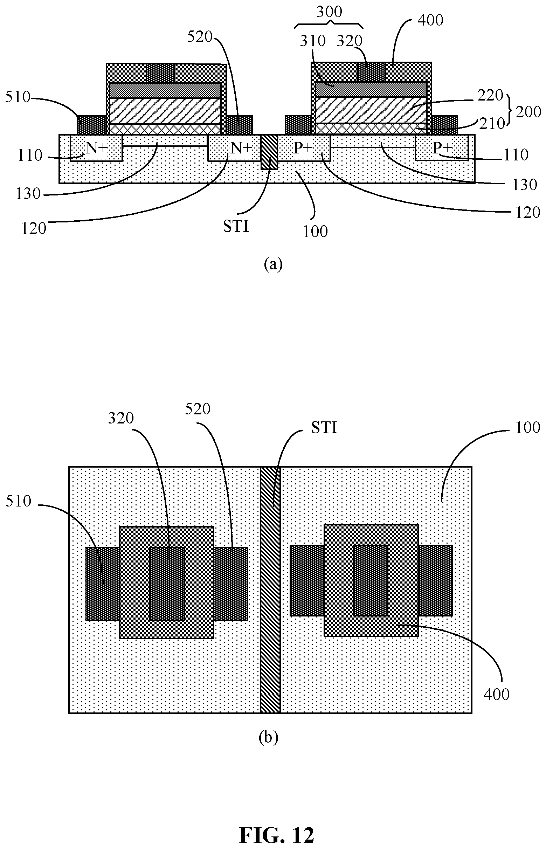

In one embodiment, referring to FIG. 6, after Step S400, the method also includes:
Step S500, performing ion implantation on the semiconductor substrate 100 positioned on two opposite sides of the gate structure 300 to form a source region 110 and a drain region 120 on the two opposite sides of the gate structure 300, referring to FIG. 12(a) and FIG. 12(b);
Step S600, forming a source electrode 510 on the source region 110, and forming a drain electrode 520 on the drain region 120, with continued reference to FIG. 12(a) and FIG. 12(b).

In this case, because the sidewall protection layer 400 and the gate electrode 320 jointly seal up the bandgap-tunable material layer 310 in Step S400, it can effectively prevent from causing adverse effects to a band structure of the bandgap-tunable material layer 310 when ion implantation is performed in Step S500.

Reference may be made to the limitations on the semiconductor structure for limitations and technical effects of the method for fabricating a semiconductor structure, and thus their detailed descriptions are omitted here.

It is to be understood that although the steps in the flowchart of FIG. 1 are sequentially displayed as indicated by the arrows, these steps are not necessarily sequentially performed in the order indicated by the arrows. Unless expressly stated herein, the execution of these steps is not strictly restrictive and may be performed in other order. Moreover, at least a part of the steps in FIG. 1 may include a plurality of steps or a plurality of stages, which are not necessarily performed at the same moment, but may be executed at different moments, and the order of execution of these steps or stages is not necessarily performed sequentially, but may be performed alternately or alternately with at least a part of the steps or stages of other steps or other steps.

Technical features of the above embodiments may be arbitrarily combined. For simplicity, all possible combinations of the technical features in the above embodiments are not described. However, as long as the combination of these technical features is not contradictory, it shall be deemed to be within the scope recorded in this specification.

The above embodiments merely express several implementations of the embodiments of the present application, and descriptions thereof are relatively concrete and detailed. However, these embodiments are not thus construed as limiting the patent scope of the present application. It is to be pointed out that for persons of ordinary skill in the art, some modifications and improvements may be made under the premise of not departing from a conception of the present application, which shall be regarded as falling within the scope of protection of the present application. Thus, the scope of protection of the patent of the present application shall be merely limited by the appended claims.

## Claims

1. A semiconductor structure, comprising:
a semiconductor substrate;
a dielectric layer positioned on the semiconductor substrate; and
a gate structure comprising a bandgap-tunable material layer, wherein the bandgap-tunable material layer is positioned on the dielectric layer, a Fermi level of the bandgap-tunable material layer shifts to a conduction band when electrons inflow, and the Fermi level of the bandgap-tunable material layer shifts to a valence band when the electrons outflow.

2. The semiconductor structure according to claim 1, wherein the semiconductor structure comprises an NMOS transistor and a PMOS transistor, both the NMOS transistor and the PMOS transistor comprising the gate structure.

3. The semiconductor structure according to claim 1, wherein the bandgap-tunable material layer comprises a graphene film layer.

4. The semiconductor structure according to claim 1, wherein the dielectric layer comprises an interface film layer and a high-k dielectric film layer, the interface film layer being positioned on a surface of the semiconductor substrate, the high-k dielectric film layer being positioned on a surface of the interface film layer, and the bandgap-tunable material layer being positioned on a surface of the high-k dielectric film layer.

5. The semiconductor structure according to claim 1, wherein the gate structure further comprises a gate electrode positioned on the bandgap-tunable material layer.

6. The semiconductor structure according to claim 5, wherein a material of the gate electrode comprises any one or more of metals, metal nitrides, metal silicides, and metal alloys.

7. The semiconductor structure according to claim 5, wherein the semiconductor structure further comprises a sidewall protection layer, the sidewall protection layer being positioned on a sidewall of the gate structure and a sidewall of the dielectric layer, and the sidewall protection layer being configured to seal up the bandgap-tunable material layer jointly with the gate electrode.

8. The semiconductor structure according to claim 7, wherein the semiconductor substrate positioned on two opposite sides of the gate structure forms a source region and a drain region, the semiconductor structure further comprising a source electrode and a drain electrode, the source electrode being positioned on the source region, and the drain electrode being positioned on the drain region.

9. A method for fabricating a semiconductor structure, comprising:
providing a semiconductor substrate;
forming a dielectric layer on the semiconductor substrate; and
forming a gate structure on the dielectric layer, wherein the gate structure comprises a bandgap-tunable material layer positioned on the dielectric layer, a Fermi level of the bandgap-tunable material layer shifts to a conduction band when electrons inflow, and the Fermi level of the bandgap-tunable material layer shifts to a valence band when the electrons outflow.

10. The method for fabricating a semiconductor structure according to claim 9, wherein the semiconductor substrate comprises a shallow trench isolation structure and a plurality of device regions isolated by the shallow trench isolation structure, each of the plurality of device regions comprising an N-type well region and a P-type well region, the P-type well region being configured to form an NMOS transistor, the N-type well region being configured to form a PMOS transistor, and the dielectric layer and the gate structure being formed on both the N-type well region and the P-type well region.

11. The method for fabricating a semiconductor structure according to claim 9, wherein the forming a gate structure on the dielectric layer comprises:
forming a graphene film layer on the dielectric layer.

12. The method for fabricating a semiconductor structure according to claim 9, wherein
the forming a dielectric layer on the semiconductor substrate comprises:
forming an interface material layer on a surface of the semiconductor substrate;
forming a high-k material layer on a surface of the interface material layer; and
patterning the interface material layer and the high-k material layer to form an interface film layer and a high-k dielectric film layer positioned on a surface of the interface film layer;
wherein the forming a gate structure on the dielectric layer comprises:
forming the bandgap-tunable material layer on a surface of the high-k dielectric film layer.

13. The method for fabricating a semiconductor structure according to claim 9, wherein the forming a gate structure on the dielectric layer comprises:
forming a gate electrode on the bandgap-tunable material layer.

14. The method for fabricating a semiconductor structure according to claim 13, wherein after the forming a gate structure on the dielectric layer, the method further comprises:
forming a sidewall protection layer on a sidewall of the gate structure and on a sidewall of the dielectric layer, the sidewall protection layer being configured to seal up the bandgap-tunable material layer jointly with the gate electrode.

15. The method for fabricating a semiconductor structure according to claim 14, wherein after the forming a sidewall protection layer on a sidewall of the gate structure and on a sidewall of the dielectric layer, the method further comprises:
performing ion implantation on the semiconductor substrate positioned on two opposite sides of the gate structure to form a source region and a drain region on the two opposite sides of the gate structure; and
forming a source electrode on the source region, and forming a drain electrode on the drain region.
